# EUROPEAN PATENT APPLICATION

(11) **EP 3 618 576 A1**
(43) Date of publication of application: **04.03.2020**
(21) Application number: 18792129.1
(22) Date of filing: 28.03.2018
(51) Int. Cl.: H05B 33/10, B26D 7/20, B26F 1/44, H01L 51/50, H05B 33/04

(54) **MANUFACTURING METHOD FOR ORGANIC DEVICE**

(30) Priority: 25.04.2017 JP 2017086104
(71) Applicant: Sumitomo Chemical Company, Limited, Tokyo 104-8260 (JP)
(72) Inventor: FUJII Takashi, Niihama-shi Ehime 792-0015 (JP); MATSUMOTO Yasuo, Niihama-shi Ehime 792-0015 (JP); MORISHIMA Shinichi, Tsukuba-shi Ibaraki 300-3294 (JP)
(74) Representative: J A Kemp LLP
(86) International application number: PCT/JP2018/013010
(87) International publication number: WO 2018/198655

(57) **Abstract**

A method for manufacturing an organic device (1) includes a forming step of forming a plurality of organic device parts (10) in which at least a first electrode layer (5), an organic functional layer (7), and a second electrode layer (9) are laminated in this order at predetermined intervals on one main surface (3a) of a support substrate (3) which extends in one direction, a bonding step of bonding a sealing member (11) which extends in the one direction in the one direction so that respective parts of the first electrode layer (5) and the second electrode layer (9) in the organic device parts (10) are exposed and straddle the plurality of organic device parts (10), and a cutting step of separating the organic device parts (10) into pieces, and in the cutting step, while an area of the one main surface (3a) of the support substrate (3) to which the sealing member (11) is not bonded and the sealing member (11) are supported by a support (100) in contact with the area and the sealing member (11), a cutting blade B is made to enter from the side of the other main surface (3b) of the support substrate (3).

## Description

### Technical Field

The present invention relates to a method for manufacturing an organic device.

### Background Art

Regarding a conventional method for manufacturing an organic device, for example, the method described in Patent Literature 1 is known. In the method for manufacturing an organic device described in Patent Literature 1, an organic device part in which a laminate in which at least a first electrode, an organic layer including at least one light emitting layer, and a second electrode are sequentially laminated on a support substrate having flexibility is formed is provided, a sealing member using a metal foil is bonded to a barrier layer via an adhesive on the second electrode of the organic device part, and then, in a part in which an adhesive layer including an adhesive and the sealing member are laminated in this order on the support substrate, a cutting blade is advanced toward the sealing member from the side of the support substrate, the structure to which the sealing member is bonded is cut in the order of the support substrate, the adhesive layer including an adhesive, and the sealing member, and individual organic EL elements are manufactured.

### Citation List

### Patent Literature

[Patent Literature 1] PCT International Publication No. WO2010/067721

### Summary of Invention

### Technical Problem

Organic devices in which respective parts of a first electrode and a second electrode are exposed and a sealing member is provided are known. When such an organic device is manufactured, the sealing member is bonded to a plurality of organic device parts and cutting is then performed so that respective parts of the first electrode and the second electrode are exposed, and thus individual organic devices can be separated into pieces. In this case, as in the conventional method for manufacturing an organic device, when the cutting blade is advanced toward the sealing member from the side of the support substrate, the following problems can occur. Specifically, the height is different between a part in which the sealing member is provided and a part in which no sealing member is provided. Therefore, when the organic device is mounted on a mounting table or the like with the sealing member on the lower side, since the part in which no sealing member is provided is not supported, when the cutting blade is advanced toward the sealing member from the side of the support substrate, the support substrate may bend, it may not be possible to appropriately cut the support substrate, and it may not be possible to appropriately separate individual organic devices into pieces.

According to one aspect of the present invention, there is provided a method for manufacturing an organic device through which individual organic devices can be appropriately separated into pieces.

### Solution to Problem

A method for manufacturing an organic device according to one aspect of the present invention includes a forming step of forming a plurality of organic device parts in which at least a first electrode layer, an organic functional layer and a second electrode layer are laminated in this order at predetermined intervals on one main surface of a support substrate which extends in one direction; a bonding step of bonding a sealing member which extends in the one direction in the one direction so that respective parts of the first electrode layer and the second electrode layer in the organic device parts are exposed and straddle the plurality of organic device parts; and a cutting step of separating the plurality of organic device parts to which the sealing member is bonded into pieces, wherein, in the cutting step, while an area of the one main surface of the support substrate to which the sealing member is not bonded and the sealing member are supported by a support in contact with the area and the sealing member, a cutting blade is made to enter from the side of the other main surface of the support substrate.

In the method for manufacturing an organic device according to one aspect of the present invention, in the cutting step, while an area of the one main surface of the support substrate to which the sealing member is not bonded and the sealing member are supported by a support in contact with the area and the sealing member, a cutting blade is made to enter from the side of the other main surface of the support substrate. In this method, since the support substrate and the sealing member are supported by the support, when the support substrate is cut, bending of the support substrate at the part to which no sealing member is bonded is prevented. Therefore, in the method for manufacturing an organic device, the organic devices can be appropriately separated into pieces.

In one embodiment, the support has a space in which the organic device part and the sealing member are able to be accommodated and which extends in one direction. In the cutting step, when the organic device part and the sealing member are positioned in the space and the sealing member is in contact with one surface that defines the space, the cutting blade may be made to enter from the side of the other main surface. In this method, it is possible to support the support substrate by the support while transporting the support substrate. Therefore, it is possible to improve the workability in the cutting step.

In one embodiment, in the support, a groove into which the cutting blade can enter may be provided at a position at which the area is supported. In this method, the support substrate can be cut while supporting the support substrate by the support.

### Advantageous Effects of Invention

According to one aspect of the present invention, individual organic devices can be appropriately separated into pieces.

### Brief Description of Drawings

FIG. 1 is a cross-sectional view of an organic EL element manufactured by a method for manufacturing an organic device according to an embodiment.
FIG. 2 is a flowchart showing a method for manufacturing an organic EL element.
FIG. 3 is a perspective view showing a state in which a sealing member is bonded to an organic device part.
FIG. 4 is a diagram for explaining a cutting step.
FIG. 5 is a diagram for explaining the cutting step.

### Description of Embodiments

Exemplary embodiments of the present invention will be described below in detail with reference to the appended drawings. Here, the same or corresponding components are denoted with the same reference numerals in the following description of drawings, and redundant descriptions thereof will be omitted.

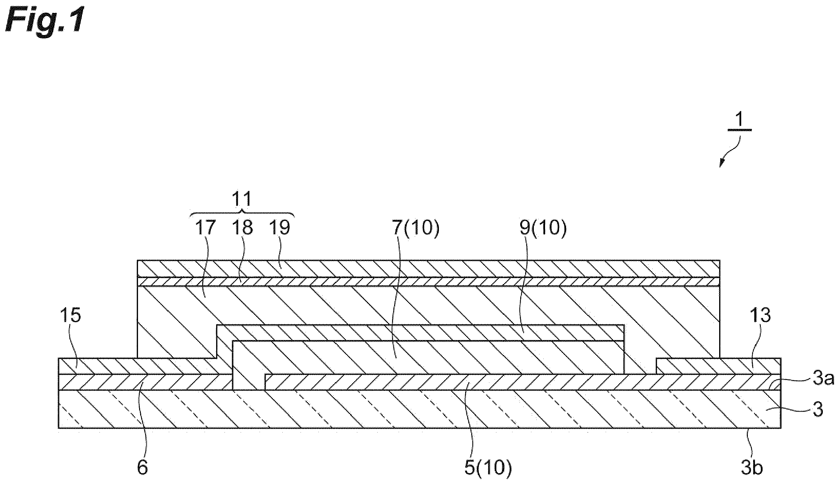

As shown in FIG. 1, an organic EL element (organic device) 1 manufactured by a method for manufacturing an organic device of the present embodiment includes a support substrate 3, an anode layer (first electrode layer) 5, an organic functional layer 7, a cathode layer (second electrode layer) 9, and a sealing member 11. The anode layer 5, the organic functional layer 7 and the cathode layer 9 constitute an organic EL part (organic device part) 10. The organic EL element 1 may include an extraction electrode 13 electrically connected to the anode layer 5 and an extraction electrode 15 electrically connected to the cathode layer 9.

### [Support substrate]

The support substrate 3 is made of a resin having transparency with respect to visible light (light with a wavelength of 400 nm to 800 nm). The support substrate 3 is a film-like substrate (a flexible substrate and a substrate having flexibility). The thickness of the support substrate 3 is, for example, 30 µm or more and 500 µm or less. When the support substrate 3 is made of a resin, preferably, the thickness is 45 µm or more in consideration of substrate deflection, wrinkles, and elongation during a continuous roll-to-roll method, and is 125 µm or less in consideration of flexibility.

The support substrate 3 is, for example, a plastic film. Examples of materials of the support substrate 3 include polyether sulfone (PES); polyester resins such as polyethylene terephthalate (PET) and polyethylene naphthalate (PEN); polyolefin resins such as polyethylene (PE), polypropylene (PP), and cyclic polyolefins; polyamide resins; polycarbonate resins; polystyrene resins; polyvinyl alcohol resins; saponified products of ethylene-vinyl acetate copolymers; polyacrylonitrile resins; acetal resins; polyimide resins; and epoxy resins.

Among the above resins, the material of the support substrate 3 is preferably a polyester resin or a polyolefin resin because it will then have a high heat resistance, a low coefficient of linear expansion, and low production costs, and is more preferably polyethylene terephthalate or polyethylene naphthalate. These resins may be used alone and two or more thereof may be used in combination.

A gas barrier layer or a water barrier layer may be disposed on one main surface 3a of the support substrate 3. The other main surface 3b of the support substrate 3 is a light emitting surface. A light extraction film may be provided on the other main surface 3b of the support substrate 3. The light extraction film may be bonded to the other main surface 3b of the support substrate 3 via an adhesive layer. The support substrate 3 may be a thin film glass. When the support substrate 3 is a thin film glass, preferably, the thickness is 30 µm or more in consideration of the strength and 100 µm or less in consideration of flexibility.

### [Anode layer]

The anode layer 5 is disposed on the one main surface 3a of the support substrate 3. An electrode layer exhibiting light transmission is used for the anode layer 5. Regarding an electrode exhibiting light transmission, a thin film made of a metal oxide, a metal sulfide or a metal having high electrical conductivity can be used, and a thin film having high light transmittance is suitably used. For example, thin films made of indium oxide, zinc oxide, tin oxide, indium tin oxide (abbreviation ITO), indium zinc oxide (abbreviation IZO), gold, platinum, silver, copper, or the like are used. Among these, a thin film made of ITO, IZO, or tin oxide is suitably used.

Regarding the anode layer 5, a transparent conductive film made of an organic material such as polyaniline and derivatives thereof, polythiophene and derivatives thereof may be used. Regarding the anode layer 5, an electrode obtained by patterning the above exemplified metals or metal alloys in a mesh shape or an electrode in which nanowires containing silver are formed into a network shape may be used.

The thickness of the anode layer 5 can be determined in consideration of light transmission, electrical conductivity, and the like. The thickness of the anode layer 5 is generally 10 nm to 10 µm, preferably 20 nm to 1 µm, and more preferably 50 nm to 200 nm.

Examples of a method of forming the anode layer 5 include a dry film forming method such as a vacuum deposition method, a sputtering method, and an ion plating method, and a coating method such as an inkjet method, a slit coating method, a gravure printing method, a screen printing method, and a spray coating method. In the anode layer 5, additionally, a pattern can be formed using a photolithographic method, a dry etching method, a laser trimming method, or the like. Direct coating is performed on the support substrate 3 using a coating method, and thus a pattern can be formed without using a photolithographic method, a dry etching method, a laser trimming method, or the like.

An electrode layer 6 is disposed on the one main surface 3a of the support substrate 3. The electrode layer 6 is disposed apart from the anode layer 5 (electrically insulated) at a predetermined interval from the anode layer 5. The thickness, material, and formation method of the electrode layer 6 may be the same as those in the anode layer 5.

The extraction electrode 13 is disposed on the anode layer 5. The extraction electrode 13 is disposed at one end (the end opposite to the end in which the extraction electrode 15 to be described below is disposed) of the support substrate 3. In the present embodiment, the end surface of the extraction electrode 13 is flush with the end surface (the end surface of the support substrate 3) of the anode layer 5. The thickness, material, and formation method of the extraction electrode 13 may be the same as those in the cathode layer 9 to be described below.

### [Organic functional layer]

The organic functional layer 7 is disposed on the main surface (the side opposite to the surface in contact with the support substrate 3) of the anode layer 5 and on the one main surface 3a of the support substrate 3. The organic functional layer 7 is disposed apart from the extraction electrode 13. The organic functional layer 7 includes a light emitting layer. The organic functional layer 7 generally contains a light emitting material that mainly emits fluorescence and/or phosphorescence or a light emitting material and a dopant material for a light emitting layer that assists the light emitting material. For example, the dopant material for a light emitting layer is added to improve luminous efficiency or change a light emission wavelength. The light emitting material that emits fluorescence and/or phosphorescence may be a low-molecular-weight compound or a high-molecular-weight compound. Examples of organic materials constituting the organic functional layer 7 include a light emitting material that emits fluorescence and/or phosphorescence such as the following dye materials, metal complex materials, and polymeric materials and the following dopant materials for a light emitting layer.

### (Dye materials)

Examples of dye materials include cyclopentamine and derivatives thereof, tetraphenylbutadiene and derivatives thereof, triphenylamine and derivatives thereof, oxadiazole and derivatives thereof, pyrazoloquinoline and derivatives thereof, distyrylbenzene and derivatives thereof, distyrylarylene and derivatives thereof, pyrrole and derivatives thereof, thiophene compounds, pyridine compounds, perinone and derivatives thereof, perylene and derivatives thereof, oligothiophene and derivatives thereof, oxadiazole dimers, pyrazoline dimers, quinacridone and derivatives thereof, and coumarin and derivatives thereof.

### (Metal complex materials)

Examples of metal complex materials include metal complexes which contains a rare earth metal such as Tb, Eu, and Dy, or Al, Zn, Be, Pt, or Ir as a central metal, and have am oxadiazole, thiadiazole, phenylpyridine, phenylbenzimidazole, or quinoline structure or the like in a ligand. Examples of metal complexes include metal complexes emitting light in a triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Polymeric materials)

Examples of polymeric materials include polyparaphenylene vinylene and derivatives thereof, polythiophene and derivatives thereof, polyparaphenylene and derivatives thereof, polysilane and derivatives thereof, polyacetylene and derivatives thereof, polyfluorene and derivatives thereof, polyvinylcarbazole and derivatives thereof, and materials obtained by polymerizing the above dye materials or metal complex materials.

### (Dopant materials for a light emitting layer)

Examples of dopant materials for a light emitting layer include perylene and derivatives thereof, coumarin and derivatives thereof, rubrene and derivatives thereof, quinacridone and derivatives thereof, squarylium and derivatives thereof, porphyrin and derivatives thereof, styryl dyes, tetracene and derivatives thereof, pyrazolone and derivatives thereof, decacyclene and derivatives thereof, and phenoxazone and derivatives thereof.

The thickness of the organic functional layer 7 is generally about 2 nm to 200 nm. For example, the organic functional layer 7 is formed by a coating method using a coating solution (for example, an ink) containing the above light emitting material. A solvent for a coating solution containing a light emitting material is not limited as long as it dissolves the light emitting material. The above light emitting material may be formed by vacuum deposition.

### [Cathode layer]

The cathode layer 9 is disposed on the main surface (the side opposite to the surface in contact with the anode layer 5) of the organic functional layer 7 and the main surface (the side opposite to the surface in contact with the support substrate 3) of the electrode layer 6. Regarding the material of the cathode layer 9, for example, alkali metals, alkaline earth metals, transition metals, and metals in Group 13 in the periodic table can be used. Regarding the material of the cathode layer 9, specifically, for example, a metal such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, an alloy of two or more of the above metals, an alloy of one or more of the above metals and one or more of gold, silver, platinum, copper, manganese, titanium, cobalt, nickel, tungsten, and tin, or graphite or a graphite intercalation compound is used. Examples of alloys include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys.

For the cathode layer 9, for example, a transparent conductive electrode made of a conductive metal oxide, a conductive organic material, or the like can be used. Specific examples of conductive metal oxides include indium oxide, zinc oxide, tin oxide, ITO, and IZO, and examples of conductive organic materials include polyaniline and derivatives thereof, polythiophene and derivatives thereof. The cathode layer 9 may have a laminate configuration in which two or more layers are laminated. An electron injection layer to be described below may be used as the cathode layer 9.

The thickness of the cathode layer 9 is set in consideration of the electrical conductivity and durability. The thickness of the cathode layer 9 is generally 10 nm to 10 µm, preferably 20 nm to 1 µm, and more preferably 50 nm to 500 nm.

Examples of a method of forming the cathode layer 9 include coating methods such as an inkjet method, a slit coating method, a gravure printing method, a screen printing method, and a spray coating method, a vacuum deposition method, a sputtering method, and a lamination method of thermocompression bonding a metal thin film, and a vacuum deposition method or a sputtering method is preferable. In the cathode layer 9, additionally, a pattern can be formed using a photolithographic method, a dry etching method, a laser trimming method, or the like.

The extraction electrode 15 is integrally formed with the cathode layer 9. The extraction electrode 15 is disposed on the electrode layer 6. The extraction electrode 15 is disposed at the other end (the end opposite to the end at which the extraction electrode 13 is disposed) of the support substrate 3. The extraction electrode 15 extends from the end of the cathode layer 9 to the other end of the support substrate 3. In the present embodiment, the end surface of the extraction electrode 15 is flush with the end surface (the end surface of the support substrate 3) of the electrode layer 6. The thickness, material, and formation method of the extraction electrode 15 may be the same as those in the cathode layer 9.

### [Sealing member]

The sealing member 11 is disposed on the top part of the organic EL element 1. The sealing member 11 includes an adhesive part 17, a barrier layer 18, and a sealing substrate 19. In the sealing member 11, the adhesive part 17, the barrier layer 18 and the sealing substrate 19 are laminated in this order. The adhesive part 17 is used to adhere the barrier layer 18 and the sealing substrate 19 to the anode layer 5, the organic functional layer 7, and the cathode layer 9. Specifically, the adhesive part 17 is made of a photocurable or thermosetting acrylate resin or a photocurable or thermosetting epoxy resin. Other resin films that can be fused with an impulse sealer which is generally used include, for example, heat-fusible films such as an ethylene vinyl acetate copolymer (EVA), a polypropylene (PP) film, a polyethylene (PE) film, and a polybutadiene (PB) film can be used. A thermoplastic resin can also be used.

The barrier layer 18 has a gas barrier function, particularly, a water barrier function. The sealing substrate 19 is made of a metal foil, a transparent plastic film, or a thin film glass having flexibility. The metal foil is preferably made of copper, aluminum, or stainless steel in consideration of barrier properties. The thickness of the metal foil is preferably thicker in consideration of prevention of pinholes, but it is preferably 10 µm to 50 µm in consideration of flexibility.

### [Method for manufacturing an organic EL element]

Subsequently, a method for manufacturing an organic EL element 1 having the above configuration will be described.

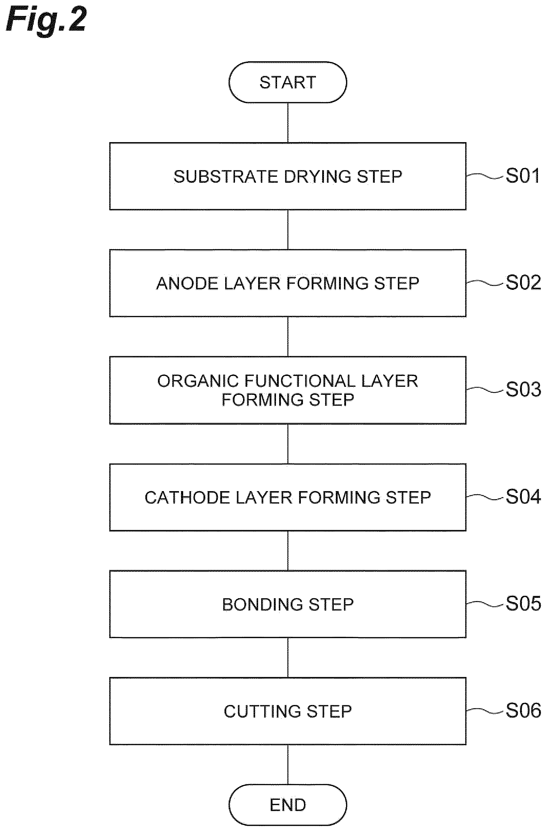

In a form in which the support substrate 3 is a substrate which has flexibility and extends in the longitudinal direction, a roll-to-roll method can be adopted from the substrate drying step S01 to bonding step S05 shown in FIG. 2.

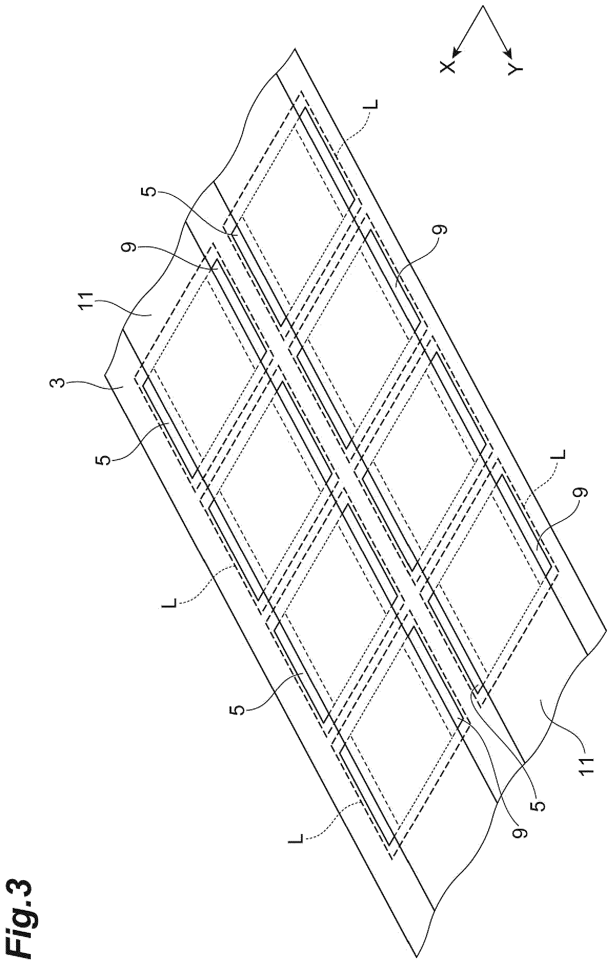

When the organic EL element 1 is manufactured, first, the support substrate 3 is heated and dried (substrate drying step S01). Next, the anode layer 5 is formed on the one main surface 3a of the dried support substrate 3 (anode layer forming step (forming step) S02). The anode layer 5 can be formed by a formation method exemplified in the description of the anode layer 5. As shown in FIG. 3, on the support substrate 3, a plurality of anode layers 5 are formed in the longitudinal direction (Y direction in FIG. 3) of the support substrate 3 at predetermined intervals, and a plurality of (two in the present embodiment) anode layers 5 are formed in the width direction (X direction in FIG. 3) of the support substrate 3 at predetermined intervals.

Subsequently, the organic functional layer 7 is formed on the anode layer 5 (organic functional layer forming step (forming step) S03). The organic functional layer 7 can be formed by a formation method exemplified in the description of the organic functional layer 7. Next, the cathode layer 9 is formed on the organic functional layer 7 (cathode layer forming step (forming step) S04). The cathode layer 9 can be formed by a formation method exemplified in the description of the cathode layer 9. Thereby, a plurality of organic EL parts 10 are formed on the support substrate 3.

Subsequently, the sealing member 11 is bonded (bonding step S05). The sealing member 11 has a predetermined width and extends in the longitudinal direction of the support substrate 3. Specifically, as shown in FIG. 3, the sealing member 11 has a width that is set so that respective parts of the anode layer 5 and the cathode layer 9 are exposed and has a strip shape. The sealing member 11 has flexibility. In the sealing member 11, the adhesive part 17 is provided on one surface of the sealing substrate 19. The sealing member 11 may be cut into a strip shape after the adhesive part 17 is formed on one surface of the sealing substrate 19 with the barrier layer 18 therebetween or the adhesive part 17 may be formed on one surface of the sealing substrate 19 with the barrier layer 18 therebetween after the sealing substrate 19 is cut into a strip shape.

The sealing member 11 is affixed to a plurality of organic EL parts 10 so that a part of the anode layer 5 and a part of the cathode layer 9 (a part of the extraction electrode 13 and a part of the extraction electrode 15) are exposed. Specifically, the sealing member 11 is affixed in one direction to straddle the plurality of organic EL parts 10. In the roll-to-roll method, the organic EL part 10 and the sealing member 11 formed on the support substrate 3 are bonded while transporting the support substrate 3. The support substrate 3 and the sealing member 11 pass between heating rollers (not shown). Thereby, the support substrate 3 and the sealing member 11 are heated by the heating rollers and pressed. Thereby, the adhesive part 17 is softened, and the adhesive part 17 is brought into close contact with the organic EL part 10. Bonding of the organic EL part 10 and the sealing member 11 is preferably performed in an environment with a low water concentration and particularly preferably performed under a nitrogen atmosphere.

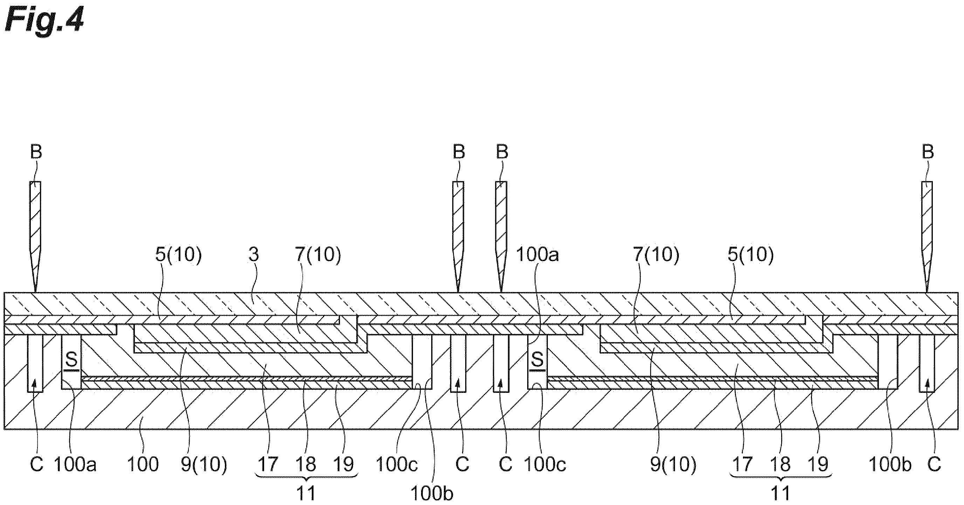

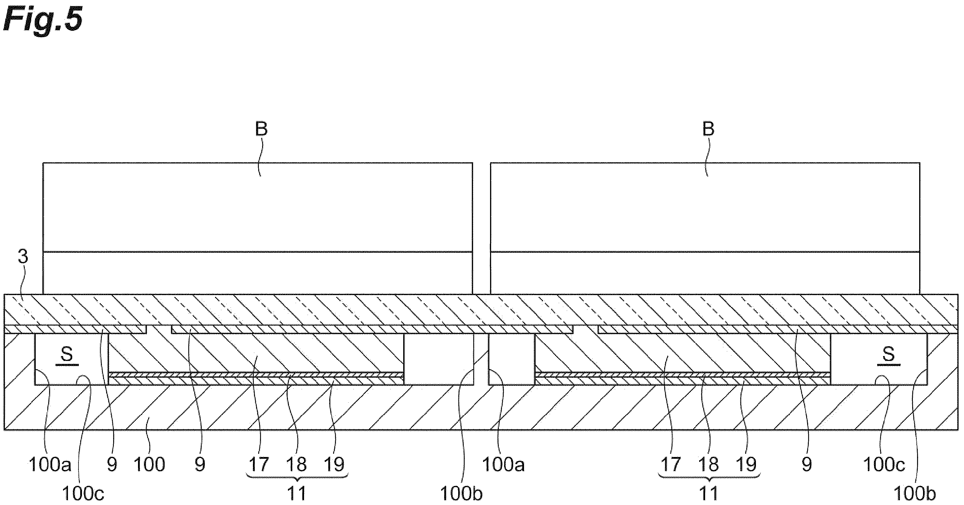

Subsequently, the plurality of organic EL parts 10 to which the sealing member 11 is bonded are separated into pieces (cutting step S06). As shown in FIG. 3, in the cutting step S06, the support substrate 3 and the sealing member 11 are cut along a cutting line L, and the plurality of organic EL parts 10 to which the sealing member 11 is bonded are separated into pieces. Specifically, as shown in FIG. 4 and FIG. 5, the support substrate 3 and the sealing member 11 are supported by a support 100, and the support substrate 3 is cut by a cutting blade B. FIG. 4 is a diagram of the cross section in the X direction in FIG. 3 when viewed in the Y direction and shows a cross section at a position including the anode layer 5 and the organic functional layer 7. FIG. 5 is a diagram of the cross section in the X direction in FIG. 3 when viewed in the Y direction and shows a cross section at a position not including the anode layer 5 and the organic functional layer 7.

The support 100 supports an area of the one main surface 3a of the support substrate 3 to which the sealing member 11 is not bonded (hereinafter referred to as an "area Z") and the sealing member 11. The support 100 has a space S in which the organic EL part 10 and the sealing member 11 are able to be accommodated. The space S is defined by a pair of sides 100a and 100b that face each other and a bottom (one surface) 100c. In the support 100, a part that faces the bottom 100c is open. The space S extends in the longitudinal direction of the support substrate 3. That is, in the space S, a plurality of organic EL parts 10 provided in the longitudinal direction of the support substrate 3 at predetermined intervals are able to be accommodated. As shown in FIG. 4, the support 100 may have a groove C. The groove C is provided at a position (a position at which the one main surface 3a is mounted) at which the cutting blade B enters. The groove C extends in the longitudinal direction of the support substrate 3. The depth of the groove C is provided to be equal to that of the bottom 100c forming the space S or lower than that of the bottom 100c.

The cutting blade B has a shape conforming to the cutting line L and has a frame shape. In the present embodiment, in the cutting blade B, four blade members are provided together. For example, a plurality of cutting blades B are provided. Thereby, in the cutting step S06, the plurality of organic EL parts 10 to which the sealing member 11 is bonded at one time can be separated into pieces. In the cutting step S06, as shown in FIG. 4 and FIG. 5, the support substrate 3 in which the plurality of organic EL parts 10 are formed is supported by the support 100. Specifically, the support substrate 3 is supported by the support 100 so that the sealing member 11 comes in contact with the bottom 100c of the support 100 and the area Z (the area in which the organic functional layer 7 is not formed) of the support substrate 3 comes in contact with the support 100. Then, the cutting blade B is made to enter from the side of the other main surface 3b of the support substrate 3. The cutting blade B is advanced to a position at which the tip thereof reaches the surface (the surface of the sealing substrate 19) of the sealing member 11. Thereby, the plurality of organic EL parts 10 to which the sealing member 11 is bonded are separated into pieces. Thereby, the organic EL element 1 shown in FIG. 1 is manufactured.

As described above, in the method for manufacturing the organic EL element 1 according to the present embodiment, in the cutting step S06, while supporting the area Z of the support substrate 3 to which the sealing member 11 is not bonded and the sealing member 11, the cutting blade B is made to enter from the side of the other main surface 3b of the support substrate 3. In this method, since the support substrate 3 and the sealing member 11 are supported, when the support substrate 3 is cut, bending of the support substrate 3 at a part to which the sealing member 11 is not bonded is prevented. Therefore, in the method for manufacturing the organic EL element 1, individual organic EL elements 1 can be appropriately separated into pieces.

In the method for manufacturing the organic EL element 1 according to the present embodiment, in the cutting step S06, the area Z and the sealing member 11 are supported by the support 100 in contact with the area Z of the support substrate 3 and the sealing member 11. In this method, the area Z of the support substrate 3 and the sealing member 11 can be appropriately supported by the support 100. Therefore, individual organic EL elements 1 can be separated into pieces more appropriately.

In the method for manufacturing the organic EL element 1 according to the present embodiment, in the cutting step S06, the support 100 having the space S in which the organic EL part 10 and the sealing member 11 are able to be accommodated and which extends in the longitudinal direction of the support substrate 3 is used. In the cutting step S06, when the organic EL part 10 and the sealing member 11 are positioned in the space S and the sealing member 11 is in contact with the bottom 100c that defines the space S, the cutting blade B is made to enter from the side of the other main surface 3b of the support substrate 3. In this method, the support substrate 3 can be supported by the support 100 while transporting the support substrate 3. Therefore, in the method for manufacturing the organic EL element 1, the workability in the cutting step S06 can be improved.

In the method for manufacturing the organic EL element 1 according to the present embodiment, in the support 100 used in the cutting step S06, the groove C into which the cutting blade B can enter is provided at a position at which the area Z of the support substrate 3 is supported. Thereby, in the method for manufacturing the organic EL element 1, the support substrate 3 can be cut while the support substrate 3 is supported by the support 100.

While embodiments of the present invention have been described above, the present invention is not necessarily limited to the above embodiments, and various modifications can be made without departing from the spirit and scope of the invention.

For example, in the above embodiment, the organic EL element 1 in which the organic functional layer 7 including a light emitting layer is disposed between the anode layer 5 and the cathode layer 9 has been exemplified. However, the configuration of the organic functional layer 7 is not limited thereto. The organic functional layer 7 may have the following configuration.
(a) (anode layer)/light emitting layer/(cathode layer)
(b) (anode layer)/hole injection layer/light emitting layer/(cathode layer)
(c) (anode layer)/hole injection layer/light emitting layer/electron injection layer/(cathode layer)
(d) (anode layer)/hole injection layer/light emitting layer/electron transport layer/electron injection layer/(cathode layer)
(e) (anode layer)/hole injection layer/hole transport layer/light emitting layer/(cathode layer)
(f) (anode layer)/hole injection layer/hole transport layer/light emitting layer/electron injection layer/(cathode layer)
(g) (anode layer)/hole injection layer/hole transport layer/light emitting layer/electron transport layer/electron injection layer/(cathode layer)
(h) (anode layer)/light emitting layer/electron injection layer/(cathode layer)
(i) (anode layer)/light emitting layer/electron transport layer/electron injection layer/(cathode layer)

Here, the symbol "/" indicates that layers between which the symbol "/" is interposed are laminated adjacent to each other. The configuration shown in the above (a) is a configuration of the organic EL element 1 in the above embodiment.

Regarding materials of a hole injection layer, a hole transport layer, an electron transport layer and an electron injection layer, known materials can be used. The hole injection layer, the hole transport layer, the electron transport layer, and the electron injection layer can be formed by, for example, a coating method as in the organic functional layer 7.

Here, the electron injection layer may contain an alkali metal or an alkaline earth metal, or an oxide or fluoride of an alkali metal or an alkaline earth metal. Examples of a film forming method of an electron injection layer include a coating method and a vacuum deposition method. In the case of the oxide and fluoride, the thickness of the electron injection layer is preferably 0.5 nm to 20 nm. Particularly, when insulation properties are strong, the electron injection layer is preferably a thin film in order to reduce increase in the drive voltage of the organic EL element 1, and the thickness thereof is preferably, for example, 0.5 nm to 10 nm, and more preferably 2 nm to 7 nm in consideration of electron injection properties.

The organic EL element 1 may include a single organic functional layer 7 or two or more organic functional layers 7. In any one of the above (a) to (i) layer configuration, when a lamination structure disposed between the anode layer 5 and the cathode layer 9 is set as a "structural unit A," as a configuration of an organic EL element including two organic functional layers 7, a layer configuration shown in the following (j) may be exemplified. Two layer configurations (structural unit A) may be the same as or different from each other. (j) anode layer/(structural unit A)/charge generation layer/(structural unit A)/cathode layer

Here, the charge generation layer is a layer that generates a hole and an electron when an electric field is applied. Examples of the charge generation layer include a thin film made of vanadium oxide, ITO, molybdenum oxide, or the like.

When "(structural unit A)/charge generation layer" is set as a "structural unit B," as a configuration of an organic EL element including three or more organic functional layers 7, a layer configuration shown in the following (k) may be exemplified. (k) anode layer/(structural unit B)x/(structural unit A)/cathode layer

The symbol "x" denotes an integer of 2 or more, and "(structural unit B)x" denotes a laminate in which x (structural units B) are laminated. A plurality of (structural unit B) layer configurations may be the same as or different from each other.

A plurality of organic functional layers 7 may be directly laminated without providing the charge generation layer to form an organic EL element.

In the above embodiment, a form in which the anode layer 5 is formed on the support substrate 3 has been exemplified. However, a roller in which the anode layer 5 is formed on the support substrate 3 in advance may be used.

In the above embodiment, a form in which, in the method for manufacturing the organic EL element 1, a step of heating and drying the support substrate 3 is performed has been exemplified. However, the drying step of the support substrate 3 may not necessarily be performed.

In the above embodiment, a form in which the space S and the groove C are provided in the support 100 has been exemplified. However, in the cutting step S06, in a form in which the area Z of the support substrate 3 to which the sealing member 11 is not bonded and the sealing member 11 are supported, the support 100 may not be used. For example, in the cutting step S06, while the sealing member 11 is mounted on the table or the like, the area Z of the support substrate 3 may be supported by the support member (for example, a columnar member or the like).

In the above embodiment, a form in which the cutting blade B has a frame shape has been exemplified. However, the shape of the cutting blade is not limited thereto. The cutting blade may have any shape as long as it can cut along the cutting line.

In the above embodiment, the organic EL element has been exemplified as an organic device. The organic device may be an organic thin film transistor, an organic photodetector, an organic thin film solar cell or the like.

In the above embodiment, a form in which the first electrode layer is the anode layer 5 and the second electrode layer is the cathode layer 9 has been exemplified. However, the first electrode layer may be the cathode layer and the second electrode layer may be the anode layer.

In the above embodiment, a form including the extraction electrodes 13 and 15 has been exemplified. However, the extraction electrode may not be provided.

In the above embodiment, as shown in FIG. 4, a form in which the electrode layer including the extraction electrode 13 and the extraction electrode 15 is in contact with the support 100 has been exemplified. However, the one main surface 3a of the support substrate 3 may be in contact with the support 100.

In the above embodiment, as shown in FIG. 4, a form in which a part of the area Z is supported by the support 100 has been exemplified. However, the entire area Z may be supported by the support.

A method for manufacturing an organic device according to one aspect of the present invention includes a forming step of forming a plurality of organic device parts in which at least a first electrode layer, an organic functional layer and a second electrode layer are laminated in this order at predetermined intervals on one main surface of a support substrate which extends in one direction, a bonding step of bonding a sealing member which extends in the one direction in the one direction so that respective parts of the first electrode layer and the second electrode layer in the organic device parts are exposed and straddle the plurality of organic device parts, and a cutting step of separating the plurality of organic device parts to which the sealing member is bonded into pieces. In the cutting step, while an area of the one main surface of the support substrate to which the sealing member is not bonded and the sealing member are supported, the cutting blade is made to enter from the side of the other main surface of the support substrate.

In the method for manufacturing an organic device according to one aspect of the present invention, in the cutting step, while an area of the one main surface of the support substrate to which the sealing member is not bonded and the sealing member are supported, the cutting blade is made to enter from the side of the other main surface of the support substrate. In this method, since the support substrate and the sealing member are supported, when the support substrate is cut, bending of the support substrate at a part to which the sealing member is not bonded is prevented. Therefore, in the method for manufacturing an organic device, the organic devices can be appropriately separated into pieces.

In one embodiment, in the cutting step, the area and the sealing member may be supported by the support in contact with the area and the sealing member. In this method, the area and the sealing member can be appropriately supported by the support. Therefore, the organic device can be separated into pieces more appropriately.

### Reference Signs List

1 Organic EL element (organic device)
3 Support substrate
3a One main surface
3b Other main surface
5 Anode layer (first electrode layer)
7 Organic functional layer
9 Cathode layer (second electrode layer)
10 Organic EL part (organic device part)
11 Sealing member
100 Support
B Cutting blade
C Groove
S Space

## Claims

1. A method of producing an organic device, comprising:
a forming step of forming a plurality of organic device parts in which at least a first electrode layer, an organic functional layer and a second electrode layer are laminated in this order are formed at predetermined intervals on one main surface of a support substrate which extends in one direction;
a bonding step of bonding a sealing member which extends in the one direction is bonded in the one direction so that respective parts of the first electrode layer and the second electrode layer in the organic device parts are exposed and straddle the plurality of organic device parts; and
a cutting step of separating the plurality of organic device parts to which the sealing member is bonded are separated into pieces,
wherein, in the cutting step, while an area of the one main surface of the support substrate to which the sealing member is not bonded and the sealing member are supported by a support in contact with the area and the sealing member, a cutting blade is made to enter from the side of the other main surface of the support substrate.

2. The method of producing an organic device according to claim 1,
wherein the support has a space in which the organic device part and the sealing member are able to be accommodated and which extends in the one direction, and
wherein, in the cutting step, when the organic device part and the sealing member are positioned in the space and the sealing member is in contact with one surface that defines the space, the cutting blade is made to enter from the side of the other main surface.

3. The method of producing an organic device according to claim 1 or 2,
wherein, in the support, a groove in which the cutting blade is able to enter is provide at a position at which the area of the one main surface is supported.
